# EUROPÄISCHE PATENTSCHRIFT

(11) **EP 1 404 903 B1**
(45) Veröffentlichungstag und Bekanntmachung des Hinweises auf die Patenterteilung: **29.03.2006**
(21) Anmeldenummer: 02751008.0
(22) Anmeldetag: 10.06.2002
(51) Int. Cl.: C30B 25/12, C23C 16/458, C30B 25/14, C23C 16/455, C30B 25/02

(54) **PROZESSKAMMER MIT ABSCHNITTSWEISE UNTERSCHIEDLICH DREHANGETRIEBENEM BODEN UND SCHICHTABSCHEIDEVERFAHREN IN EINER DERARTIGEN PROZESSKAMMER**
PROCESS CHAMBER WITH A BASE WITH SECTIONALLY DIFFERENT ROTATIONAL DRIVE AND LAYER DEPOSITION METHOD IN SUCH A PROCESS CHAMBER
CHAMBRE DE TRAITEMENT DOTEE D'UN FOND AYANT DIFFERENTES SECTIONS ENTRAINEES EN ROTATION ET PROCEDE DE DEPOT DE COUCHES DANS CETTE CHAMBRE DE TRAITEMENT

(30) Priorität: 12.07.2001 DE 10133914
(43) Veröffentlichungstag der Anmeldung: 07.04.2004
(73) Patentinhaber: Aixtron AG, 52072 Aachen (DE)
(72) Erfinder: SCHWAMBERA, Markus, 52064 Aachen (DE); FRANKEN, Walter, 52249 Eschweiler (DE); STRAUCH, Gerd, 52072 Aachen (DE)
(74) Vertreter: Grundmann, Dirk
(86) Internationale Anmeldenummer: PCT/EP2002/006294
(87) Internationale Veröffentlichungsnummer: WO 2003/008675

(56) Entgegenhaltungen:
- US-A- 5 788 777
- FRIJLINK P M ET AL: "LAYER UNIFORMITY IN A MULTIWAFER MOVPE REACTOR FOR III-V COMPOUNDS" JOURNAL OF CRYSTAL GROWTH, NORTH-HOLLAND PUBLISHING CO. AMSTERDAM, NL, Bd. 107, Nr. 1 / 4, 1991, Seiten 166-174, XP000246591 ISSN: 0022-0248
- FRIJLINK P M: "A NEW VERSATILE, LARGE SIZE MOVPE REACTOR" JOURNAL OF CRYSTAL GROWTH, NORTH-HOLLAND PUBLISHING CO. AMSTERDAM, NL, Bd. 93, Nr. 1 - 4, 1. November 1988 (1988-11-01), Seiten 207-215, XP000034974 ISSN: 0022-0248

## Beschreibung

Die Erfindung betrifft ein Verfahren zum Abscheiden insbesondere kristalliner Schichten auf in einer Prozesskammer auf drehangetriebenen Substrathaltern aufliegenden Substraten, wobei die Substrathalter um das Zentrum eines drehangetriebenen Substrathalterträgers angeordnet sind, welche Substrathalter gemeinsam mit dem Substrathalterträger einen Prozesskammerboden bilden, dem eine Prozesskammerdecke mit zentralem Gaseinlassorgan gegenüberliegt, durch welches zusammen mit einem Trägergas ein- oder mehrere gasförmige Ausgangsstoffe in eine über einem beheizten Zentralbereich des Prozesskammerbodens angeordnete Zerlegungszone eingeleitet werden, die von einer Diffusionszone umgeben ist, aus welcher die im radial auswärts strömenden Trägerstrom transportierten Zerlegungsprodukte zum Substrat gelangen.

Die Erfindung betrifft ferner eine Vorrichtung zum Abscheiden, insbesondere kristallinier Schichten auf in einer Prozesskammer der Vorrichtung auf drehantreibbaren Substrathaltern aufliegenden, insbesondere kristallinen Substraten, wobei die Substrathalter um das Drehzentrum eines drehantreibbaren Substrathalterträgers angeordnet sind, welche Substrathalter gemeinsam mit dem Substrathalterträger einen Prozesskammerboden bilden, dem eine Prozesskammerdecke mit zentralem Gaseinlassorgan gegenüberliegt, wobei der Zentralbereich des Prozesskammerbodens zufolge einer Beheizung Wärme an ein oder mehrere in die Prozesskammer durch das Gaseinlassorgan eingeleitete gasförmige Ausgangsstoffe abgibt.

Eine derartige Vorrichtung bzw. ein derartiges Verfahren gehören zum Stand der Technik. Als Substrate werden insbesondere Halbleiterscheiben verwendet. Es können sich um III-V Halbleiterscheiben handeln. Diese, auch als 'Wafer" bezeichneten Scheiben werden auf die Substrathalter gelegt. Die Substrathalter werden, wie es das US-Patent 4860687 beschreibt, drehangetrieben. Dort haben die Substrathalter eine kreisscheibenförmige Gestalt und rotieren. Sie drehen beispielsweise auf einem Gaspolster , welches von in den Substrathalterträger eingebrachten, dort durch Kanäle fließende Gasströme aufrecht erhalten wird. Durch eine besondere, insbesondere spiralbogennutförmige Austrittsdüse ist gewährleistet, dass der Gasstrom nicht nur ein tragendes, sondern auch ein drehantreibendes Gaspolster für die Substrathalterscheiben bildet. Alternativ dazu sind auch mechanische Drehantriebe im Stand der Technik bekannt. Die Substrathalterscheiben sind planetenartig um das Zentrum des Substrathalterträgers angeordnet. Der Substrathalterträger ist selbst drehangetrieben. Dies beschreibt beispielsweise die DE 19043600. Über dem Zentrum des Substrathalterträgers befindet sich ein der Decke der Prozesskamer zugeordnetes Gaseinlassorgan. Das Gaseinlassorgan besitzt mehrere Gasaustrittszonen. Durch eine zentrale Gasaustrittszone fließt das Hydrid, beispielsweise Arsin oder Phosphin. Durch dazu periphere Gasaustrittszonen strömen die metallorganischen Komponenten, beispielsweise Trimethylgalium oder Trimethylindium in die Prozesskammer. Der Prozesskammerboden wird von unten beispielsweise mittels einer Hochfrequenzheizung beheizt. Die Prozesskammerdecke kann bedarfsweise ebenfalls beheizt oder auch gekühlt werden. Der unmittelbar unterhalb des Gaseinlassorganes angeordnete Zentralbereich des Prozesskammerbodens gibt über Strahlung aber insbesondere über Wärmeleitung Wärme an das aus dem Gaseinlassorgan in die Prozesskammer einströmende Prozessgas ab. Die innerhalb des Prozessgases mittels eines Trägergasstromes transportierten gasförmigen Ausgangsstoffe zerlegen sich pyrolytisch zufolge bzw. Zerlegung dieser Erwärmung. Im Idealfall soll die Erwärmung in Umfangsrichtung völlig gleichförmig erfolgten, damit die planetenartig um das Zentrum des Substrathalterträgers angeordneten Substrate gleichmässig mit Zerlegungsprodukten versorgt werden, welche aus der sich um den Zentralbereich erstreckenden Diffusionszone zum Substrat diffundieren und dort eine Schicht aufbauen. Im Realfall ist ein exakte rotationssymmetrische Zerlegungszone nicht zu erreichen, da zur Folge Materialinhomogenitäten oder Toleranzen in den Fertigungsmaßen eine homogene Temperaturverteilung im Zentralbereich nicht zu erreichen ist.

Der Erfindung liegt daher die Aufgabe zugrunde, Maßnahmen anzugeben, mittels derer die Versorgung der Substrate mit Zerlegungsprodukten vergleichmäßigt wird.

Gelöst wird die Aufgabe zunächst und im wesentlichen durch die in den Ansprüchen 1 und 2 angegebenen Lösungen, wobei darauf abgestellt ist, dass der Zentralbereich des Prozesskammerbodens relativ zum Substrathalterträger und zur Prozesskammerdecke bzw. zum Gaseinlassorgan drehantreibbar ist bzw. drehangetrieben wird. Die in den weiteren Ansprüchen angegebenen Gegenstände betreffen sowohl vorteilhafte Weiterbildungen zum Gegenstand des im Anspruch 1 angegebenen Verfahrens bzw. der im Anspruch 2 angegebenen Vorrichtung als auch gleichzeitig davon und von der o. g. Aufgabenstellung unabhängige, eigenständige technische Lösungsvorschläge. Es wird dort insbesondere vorgeschlagen, dass die Substrathalter und eine mit ihrer Oberfläche den Zentralbereich bildende Zentrumsplatte auf einem Gaspolster oder mechanisch drehgelagert sind. Indem die Zentrumsplatte auf einem Gaspolster liegt, kann die Wärmezufuhr zur Zentrumsplatte über die Wärmeleitfähigkeit des Gases eingestellt werden. Es ist deshalb vorgesehen, dass das Gaspolster bildende Gas aus verschiedenen Komponenten bestehen kann. Eine Komponente kann ein Gas mit einer hohen Wärmeleitfähigkeit sein. Die andere Komponente kann ein Gas mit einer geringen Wärmeleitfähigkeit sein. Durch eine geeignete Mischung der beiden Gase lässt sich der Wärmetransport und damit die Oberflächentemperatur einstellen. Die Zentrumsplatte kann aber auch von einem Getriebe oder andersartig drehangetrieben werden. Zur Folge der Drehung der Zentrumsplatte werden in Umfangsrichtung vorhandene Inhomogenitäten der Oberflächentemperatur der Zentrumsplatte ausgemittelt. Die Zentrumsplatte kann aus Graphit bestehen. Sie kann beschichtet sein. Sie kann aus einem inerten Metall, beispielsweise aus Molybden, aus Keramik oder aus Quarz bestehen. Die Zentrumsplatte kann sich in derselben Richtung drehen wie der Substrathalterträger. Sie läuft dann insgesamt mit einer höheren Drehzahl relativ zum Gaseinlassorgan bzw. zur Prozesskammerdecke. Die Zentrumsplatte kann sich aber auch in entgegengesetzter Richtung drehen. Es sollte allerdings sichergestellt sein, dass die Drehzahl von der Drehzahl des Substrathalterträgers abweicht, damit die erforderliche Relativbewegung zum Gaseinlassorgan oder zur Prozesskammerdecke gewährleistet ist. In einer bevorzugten Ausgestaltung der Erfindung ist vorgesehen, dass die Zentrumsplatte von dem Substrathalterträger getragen wird. Dies hat den Vorteil, dass sich die Zentrumsplatte relativ zur Prozesskammerdecke bzw. zum Gaseinlassorgan schneller drehen kann, als der Substrathalterträger. In einer bevorzugten Ausgestaltung der Erfindung besteht der Substrathalterträger aus einem äußeren Ringteil, welcher die Substrathalter aufnimmt. Dieser äußere Ringteil wird mittels zweier im Zentrum des Ringteiles angeordneter Spannplatten gespannt. Diese Spannplatten können mit Gaszuleitungsrohren verschraubt sein, welche eine koaxiale Anordnung zueinander haben. In dem zentralen Ringfreiraum kann die Zentrumsplatte angeordnet sein. Die Zentrumsplatte liegt dann in einer topfförmigen Aussparung, deren Wände von den Ringinnenwänden des Ringkörpers gebildet werden. Der Boden dieser topfförmigen Aussparung wird von der oben liegenden Spannplatte gebildet. Die Anordnung der Spannplatten in Bezug auf den ringförmigen Körper beschreibt beispielsweise die DE 19043600.

Ausführungsbeispiele der Erfindung werden nachfolgend anhand beigefügter Zeichnungen erläutert. Es zeigen:

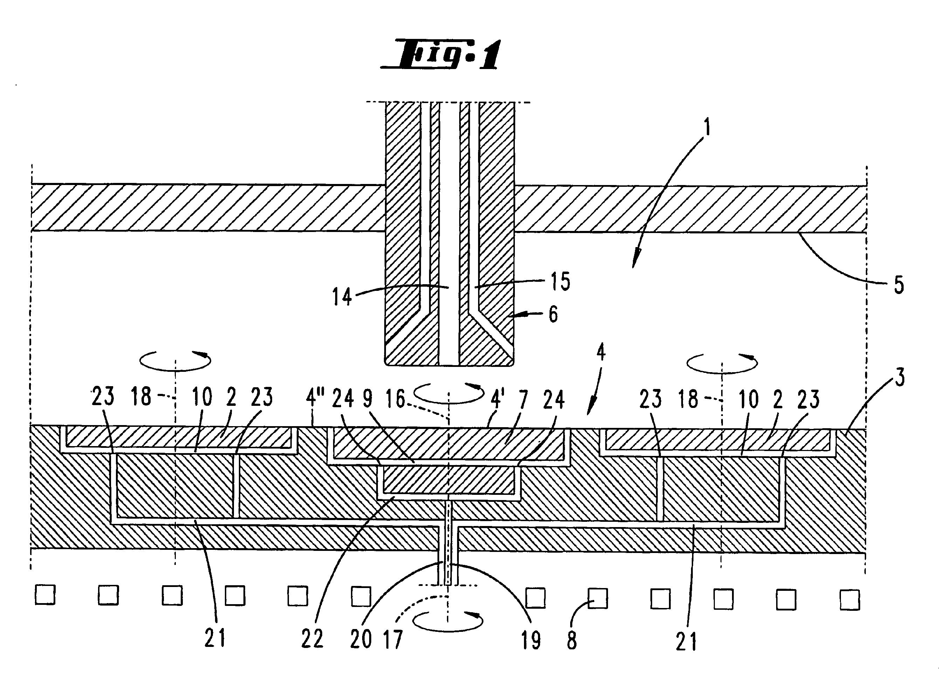

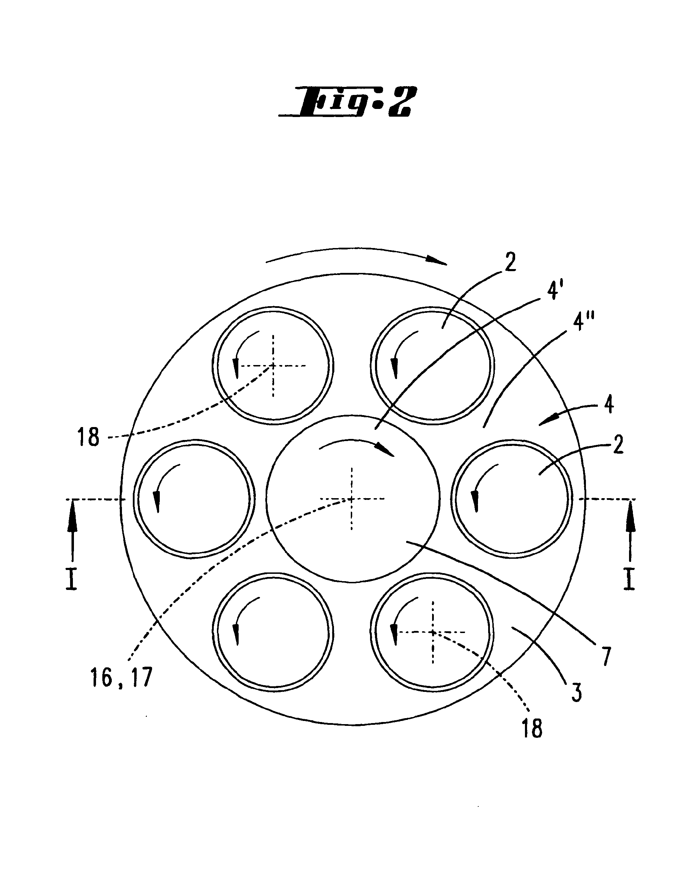

- Fig. 1: Einen Diagonalschnitt durch das Zentrum einer Prozesskammer einer erfindungsgemäßen Vorrichtung (Schnitt gemäß der Linie I-I Fig. 2).
- Fig. 2: die Draufsicht auf den Prozesskammerboden der Vorrichtung gemäß Fig.1 und

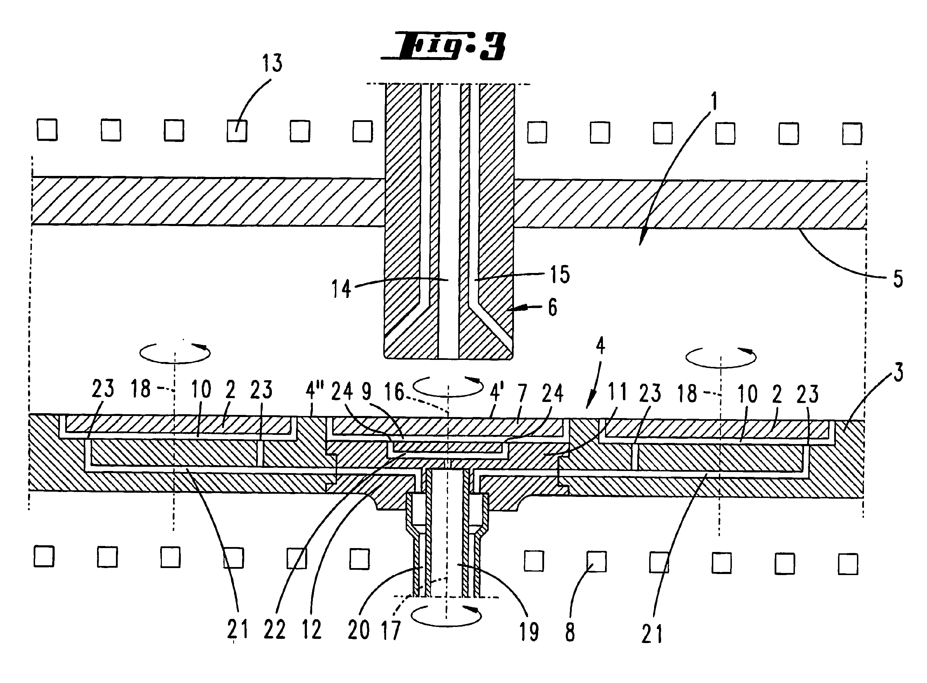

- Fig. 3: eine Darstellung gemäß Fig.1 in einem Schnitt, der der Linie I-1 in Fig. 2 entspricht.

Die Prozesskammer 1 besitzt eine zylindersymmetrische Gestalt. Sie besitzt einen Boden 4 und eine Decke 5. Die Decke 5 kann aus einer Graphitplatte 2 bestehen. In ihrem Zentrum besitzt die kreisscheibenförmige Graphitplatte 5 eine Öffnung. Durch diese Öffnung ragt ein Gaseinlassorgan 6 von außerhalb bis in die Prozesskammer 1. Das Gaseinlassorgan 6 besitzt eine zentrale Zuleitung 14, durch welches AₛH₃ oder PH₃ zugeleitet wird. Die Zuleitung erfolgt zusammen mit einem Trägergas, beispielsweise H₂ oder N₂. Peripher um die Hydridzuleitung 14 erstreckt sich die MO-Zuleitung 15, durch welche ebenfalls mit einem Trägergas die metallorganischen Komponenten, beispielsweise TMI oder TMG in die Prozesskammer eingeleitet werden.

Der erwähnte Prozesskammerboden 4 wird im wesentlichen von einem Substrathalterträger 3 gebildet, bei dem es sich um eine drehangetriebene Platte handelt, die aus demselben Material wie die Prozesskammerdecke 5 bestehen kann. Der Prozesskammerboden 4 kann aus Graphit, Metall, Quarz oder Keramik bestehen.

Der Substrathalterträger 3 besitzt mehrere, umfangsgleich verteilt mit gleichem Radialabstand zum Zentrum angeordnete topfförmige Aussparungen. In diese topfförmigen Aussparungen münden Kanäle 21 in Form von Düsen 23. Die Ausgestaltung der Düsen beschreibt das US-Patent 4860687. Es wird hierzu auf diese Schrift verwiesen. Die Düsen 23 sind so ausgestaltet, dass die in den topfförmigen Aussparungen liegenden kreisscheibenförmigen Substrathalter 2 von dem aus den Düsen 23 austretenden Gasstrom drehangetrieben werden. Die Substrathalter 2 liegen auf einem Gaspolster. Die Substrathalter 2 befinden sich in einer peripheren Zone 4" des Bodens 4. Diese Zone entspricht der Diffusionszone in der darüberliegenden Gasphase. Aus dieser Zone sollen die in einer im Zentrumsbereich liegenden Zerlegungszone entstandenen Zerlegungsprodukte transportiert werden, um zum Substrat zu gelangen.

Der Zentralbereich 4' des Prozesskammerbodens 4 wird von einer drehangetriebenen Zentrumsplatte 7 gebildet. Diese Zentrumsplatte besitzt ebenso wie die Substrathalter 2 eine Kreisscheibenform. Ihr Durchmesser ist im Ausführungsbeispiel jedoch größer als der Durchmesser der Substrathalter 2. Der Durchmesser der Zentrumsplatte 7 kann aber auch anders dimensioniert sein. Er kann beispielsweise kleiner sein als der Durchmesser der Substrathalter 2. Die Zentrumsplatte 7 liegt auch auf einem Gaspolster. Dieses Gaspolster wird von einem Gas aufrecht erhalten, welches durch eine Gaszuleitung 19 und durch Kanäle 22 aus den Düsen 24 austritt. Hinsichtlich der Gestaltung der Düsen wird auch hier auf das US 4860687 verwiesen. Auch die Düsen 24 sind in der Lage, nicht nur das Gaspolster zu bilden, auf welchem die Zentrumsplatte 7 liegt. Die Düsen sorgen auch für einen Drehantrieb der Zentrumsplatte 7. Die Zentrumsplatte 7 dreht sich bevorzugt in derselben Richtung, wie der Substrathalterträger 3, welcher über die Gaszuleitung 19 und 20 bildenden Rohre angetrieben wird. Optimal fallen die Drehachse 16 der Zentrumsplatte 7 und die Drehachse 18 des Substrathalters 3 zusammen. Die Drehbewegung der Zentrumsplatte 7 kann auch auf mechanische Weise erfolgen, beispielsweise über einen Antriebsmotor und Übertragungswellen oder Räder.

Durch die Koaxialrohranordnung der Gaszuleitungen 19, 20 fliest im zentralen Rohr 19 dass für das Gaspolster und den Drehantrieb der Zentrumsplatte 7 benötigte Gas. Der Substrathalterträger 3 wird von unten mittels einer Hochfrequenzheizung 8 beheizt. Es ist aber auch möglich, den Substrathalter mittels Infrarotlicht oder über einen elektrischen Widerstand zu beheizen. Über im wesentlichen Wärmeleitung und Wärmestrahlung wird die Zentrumsplatte 7 beheizt. Der Wärmetransport durch den Gasspalt 9 kann durch eine Änderung der Wärmeleitfähigkeit des Gases beeinflusst werden. Damit ist auch die Oberflächentemperatur im Zentralbereich 4' beeinflussbar. Zur Variation der Wärmeleitfähigkeit ist es möglich, beispielsweise ein Gemisch von Wasserstoff und Stickstoff durch die Rohrleitung 19 in verschiedenen Mischungsverhältnissen zu geben.

Auch der Wärmeübergang vom Substrathalterträger zum Substrathalter 2 kann über die Beschaffenheit des Gaspolster 10 bildenden Gases eingestellt werden. Die Zentrumsplatte 7 kann aus Graphit, aus einem inerten Metall, beispielweise Molybden, Keramik oder aus Quarz bestehen. Zufolge des drehangetriebenen Zentralbereichs 4' mitteln sich in Umfangsrichtung verlaufende Inhomogenitäten aus. Zur Folgen einer viskosen Ankopplung des Gases oberhalb der Zentrumsplatte 7 wird das Gas dort drehmitgeschleppt. Dies führt zu einer Erhöhung der Homogenität damit zu geringfügigen Abweichungen der Schichtqualitäten der Schichten der einzelnen Substrate.

## Patentansprüche

1. Verfahren zum Abscheiden insbesondere kristalliner Schichten auf in einer Prozesskammer (1) auf drehangetriebenen Substrathaltern (2) aufliegenden Substraten, wobei die Substratehalter (2) um das Zentrum eines drehangetriebenen Substrathalterträgers angeordnet sind, welche Substrathalter (2) gemeinsam mit dem Substrathalterträger (3) einen Prozesskammerboden (4) bilden, dem eine Prozesskammerdecke (5) mit zentralem Gaseinlassorgan (6) gegenüberliegt, durch welches zusammen mit einem Trägergas ein oder mehrere gasförmige Ausgangsstoffe in eine im über einem beheizten Zentralbereich (4') des Prozesskammerbodens (4) angeordnete Zerlegungszone eingeleitet werden, die von einer Diffusionszone (4") umgeben ist, aus welcher die im radial auswärts strömenden Trägergasstrom transportierten Zerlegungsprodukte zum Substrat gelangen, **dadurch gekennzeichnet, dass** der Zentralbereich (4') des Prozesskammerbodens (4) relativ zum Substrathalterträger (3) und zur Prozesskammerdecke (5) bzw. zum Gaseinlassorgan (6) drehangetrieben wird.

2. Vorrichtung zum Abscheiden insbesondere kristalliener Schichten auf in einer Prozesskammer (1) der Vorrichtung auf drehantreibbaren Substraten (2) aufliegenden, insbesondere kristallienen Substraten, wobei die Substrathalter (2) das Drehzentrum eines drehantreibbaren Substrathalterträgers (3) angeordnet sind, welche Substrathalter (2) gemeinsam mit dem Substrathalterträger (3) einen Prozesskammerboden (4) bilden, dem eine Prozesskammerdekke (5) mit zentralem Gaseinlassorgan (6) gegenüberliegt, wobei der Zentralbereich (4') des Prozesskammerbodens (5) zufolge einer Beheizung (8) Wärme an ein oder mehrere in die Prozesskammer (1) durch das Gaseinlassorgan (6) eingeleitete gasförmige Ausgangsstoffe abgibt, **dadurch gekennzeichnet, dass** der Zentralbereich (4') des Prozesskammerbodens (4) relativ zum Substrathalterträger (3) und zur Prozesskammerdecke (5) bzw. zum Gaseinlassorgan (6) drehantreibbar ist.

3. Verfahren oder Vorrichtung nach einem oder mehreren der vorhergehenden Ansprüche oder insbesondere danach, **dadurch gekennzeichnet, dass** die Substrathalter (2) und eine mit ihrer Oberfläche den Zentralbereich (4') bildende Zentrumsplatte (7) auf einem Gaspolster (9,10) drehgelagert sind.

4. Verfahren oder Vorrichtung nach einem oder mehreren der vorhergehenden Ansprüche oder insbesondere danach, **dadurch gekennzeichnet, dass** die Wärmeleitfähigkeit des die Zentrumsplatte (7) tragenden und drehantreibenden Gaspolsters (9) durch Wahl der Gasmischung einstellbar ist, wobei die Gasmischung aus einem Gas mit einer hohen und einem Gas mit einer geringen thermischen Leitfähigkeit besteht.

5. Verfahren oder Vorrichtung nach einem oder mehreren der vorhergehenden Ansprüche oder insbesondere danach, **dadurch gekennzeichnet, dass** die Zentrumsplatte (7) aus Graphit, insbesondere beschichtetem Graphit, einem inerten Metall, beispielsweise Molybdän, Keramik oder Quarz besteht.

6. Verfahren oder Vorrichtung nach einem oder mehreren der vorhergehenden Ansprüche oder insbesondere danach, **dadurch gekennzeichnet, dass** die Zentrumsplatte gegenläufig oder gleichläufig zum Substrathalterträger dreht.

7. Verfahren oder Vorrichtung nach einem oder mehreren der vorhergehenden Ansprüche oder insbesondere danach, **dadurch gekennzeichnet, dass** die Zentrumsplatte (7) von Substrathalterträger (3) getragen wird.

8. Verfahren oder Vorrichtung nach einem oder mehreren der vorhergehenden Ansprüche oder insbesondere danach, **dadurch gekennzeichnet, dass** der Substrathalterträger (3) mehrteilig ist und inbesondere von zwei Spannplatten (11, 12) zentral gehalten ist, wobei die Zentrumsplatte (7) über der obersten Spannplatte (11) liegt.

9. Verfahren oder Vorrichtung nach einem oder mehreren der vorhergehenden Ansprüche oder insbesondere danach, **gekennzeichnet durch** eine koaxiale Zuleitung (19,20) der die Gaspolster (9, 10) bildenden Gasströme.

10. Verfahren oder Vorrichtung nach einem oder mehreren der vorhergehenden Ansprüche oder insbesondere danach, **dadurch gekennzeichnet, dass** die Zentrumsplatte (7) mechanisch insbesondere über eine Antriebswelle oder über Antriebsräder drehangetrieben wird.

## Claims

1. Method for depositing in particular crystalline layers on substrates lying on rotationally driven substrate holders (2) in a process chamber (1), the substrate holders (2) being disposed around the center of a rotationally driven substrate holder carrier, which substrate holders (2) together with the substrate holder carrier (3) form a process chamber base (4), opposite which there is a process chamber cover (5) with a central gas inlet element (6), through which one or more gaseous starting materials are introduced together with a carrier gas into a decomposition zone which is disposed above a heated central region (4') of the process chamber base (4) and is surrounded by a diffusion zone (4''), from which the decomposition products transported in the radially outwardly flowing carrier gas stream reach the substrate, **characterized in that** the central region (4') of the process chamber base (4) is rotationally driven in relation to the substrate holder carrier (3) and the process chamber cover (5) or the gas inlet element (6).

2. Apparatus for depositing in particular crystalline layers on in particular crystalline substrates resting on rotationally drivable substrates (2) in a process chamber (1) of the apparatus, the substrate holders (2) being disposed the rotational center of a rotationally drivable substrate holder carrier (3), which substrate holders (2) together with the substrate holder carrier (3) form a process chamber base (4), opposite which there is a process chamber cover (5) with a central gas inlet element (6), the central region (4') of the process chamber base (5) giving off heat to one or more gaseous starting materials introduced into the process chamber (1) through the gas inlet element (6) as a result of heating (8), **characterized in that** the central region (4') of the process chamber base (4) is rotationally drivable in relation to the substrate holder carrier (3) and the process chamber cover (5) or the gas inlet element (6).

3. Method or apparatus according to one or more of the preceding claims or in particular according thereto, **characterized in that** the substrate holders (2) and a center plate (7), which with its surface forms the central region (4'), are rotationally mounted on a gas cushion (9, 10).

4. Method or apparatus according to one or more of the preceding claims or in particular according thereto, **characterized in that** the thermal conductivity of the gas cushion (9) carrying and rotationally driving the center plate (7) can be set by choosing the gas mixture, the gas mixture comprising a gas with a high thermal conductivity and a gas with a low thermal conductivity.

5. Method or apparatus according to one or more of the preceding claims or in particular according thereto, **characterized in that** the center plate (7) consists of graphite, in particular coated graphite, an inert metal, for example molybdenum, ceramic or quartz.

6. Method or apparatus according to one or more of the preceding claims or in particular according thereto, **characterized in that** the center plate rotates in the same direction as or in the opposite direction than the substrate holder carrier.

7. Method or apparatus according to one or more of the preceding claims or in particular according thereto, **characterized in that** the center plate (7) is carried by substrate holder carrier (3).

8. Method or apparatus according to one or more of the preceding claims or in particular according thereto, **characterized in that** the substrate holder carrier (3) comprises more than one part and in particular is held centrally by two clamping plates (11, 12), the center plate (7) lying above the uppermost clamping plate (11).

9. Method or apparatus according to one or more of the preceding claims or in particular according thereto, **characterized by** a coaxial supply line (19, 20) of the gas streams forming the gas cushions (9, 10).

10. Method or apparatus according to one or more of the preceding claims or in particular according thereto, **characterized in that** the center plate (7) is rotationally driven mechanically, in particular by means of a drive shaft or by means of drive wheels.

## Revendications

1. Procédé de déposition de couches, notamment de couches cristallines, sur des substrats placés sur des porte-substrats (2) entraînés en rotation dans une chambre de traitement (1), les porte-substrats (2) étant disposés autour du centre d'un support de porte-substrat entraîné en rotation, lesquels porte-substrats (2) forment conjointement avec le support (3) de porte-substrat un fond de chambre de traitement (4) en face duquel se trouve un capot de chambre de traitement (5) comportant un organe central d'admission de gaz (6) permettant d'introduire une ou plusieurs substances gazeuses de base, conjointement avec un gaz de support, dans une zone de décomposition qui est située au-dessus d'une région centrale chauffée (4') du fond de chambre de processus (4) et qui est entourée d'une zone de diffusion (4") d'où proviennent les produits de décomposition, transportés dans le flux de gaz de support s'écoulant radialement vers l'extérieur, pour aller jusqu'au substrat, **caractérisé en ce que** la région centrale (4') du fond de chambre de processus (4) est entraînée en rotation par rapport au support de porte-substrat (3) et au capot de chambre de traitement (5).

2. Dispositif de déposition de couches, notamment de couches cristallines, sur des substrats (2), notamment des substrats cristallins, placés sur des porte-substrats (2) entraînés en rotation dans une chambre de traitement (1) du dispositif, les porte-substrats (2) étant disposés autour du centre de rotation d'un support de porte-substrat (3) pouvant être entraîné en rotation, lesquels porte-substrats (2) forment conjointement avec le support de porte-substrat (3) un fond de chambre de traitement (4) en face duquel se trouve un capot de chambre de traitement (5) doté d'un organe central d'admission de gaz (6), la région centrale (4') du fond de chambre de traitement (5) délivrant, conformément à un chauffage (8), de la chaleur à une ou plusieurs substances gazeuses de base introduites dans la chambre de traitement (1) par l'organe d'admission de gaz (6), **caractérisé en ce que** la région centrale (4') du fond de chambre de traitement (4) peut être entraînée en rotation par rapport au support de porte-substrat (3) et au capot de chambre de traitement (5) respectivement à l'organe d'admission de gaz (6).

3. Procédé ou dispositif, en particulier selon l'une ou plusieurs des revendications précédentes, **caractérisé en ce que** les porte-substrats (2) et une plaque centrale (7), dont la surface forme la région centrale (4'), sont montés à rotation sur un coussin de gaz (9, 10).

4. Procédé ou dispositif, en particulier selon l'une ou plusieurs des revendications précédentes, **caractérisé en ce que** la conductivité thermique du coussin de gaz (9), supportant la plaque centrale (7) et pouvant être entraîné en rotation, peut être réglée en choisissant le mélange de gaz, le mélange de gaz étant constitué d'un gaz présentant une conductivité thermique élevée et d'un gaz présentant une conductivité thermique faible.

5. Procédé ou dispositif, en particulier selon l'une ou plusieurs des revendications précédentes, **caractérisé en ce que** la plaque centrale (7) est constituée de graphite, notamment de graphite enduit, d'un métal inerte, par exemple du molybdène, de céramique ou de quartz.

6. Procédé ou dispositif, en particulier selon l'une ou plusieurs des revendications précédentes, **caractérisé en ce que** la plaque centrale tourne dans le même sens que le support de porte-substrat, ou dans le sens opposé.

7. Procédé ou dispositif, en particulier selon l'une ou plusieurs des revendications précédentes, **caractérisé en ce que** la plaque centrale (7) est supportée par des supports de porte-substrat (3).

8. Procédé ou dispositif, en particulier selon l'une ou plusieurs des revendications précédentes, **caractérisé en ce que** le support (3) de porte-substrat comporte plusieurs pièces et est supporté au centre, notamment par deux plaques de serrage (11, 12), la plaque centrale (7) se trouvant au-dessus de la plaque de serrage supérieure (11).

9. Procédé ou dispositif, en particulier selon l'une ou plusieurs des revendications précédentes, **caractérisé par** une amenée coaxiale (19, 20) des flux de gaz formant le coussin de gaz (9, 10).

10. Procédé ou dispositif, en particulier selon l'une ou plusieurs des revendications précédentes, **caractérisé en ce que** la plaque centrale (7) est entraînée en rotation par des moyens mécaniques, notamment par un arbre d'entraînement ou par des roues d'entraînement.
